# EUROPEAN PATENT SPECIFICATION

(11) **EP 0 453 937 B1**
(45) Date of publication and mention of the grant of the patent: **16.07.1997**
(21) Application number: 91106121.6
(22) Date of filing: 17.04.1991
(51) Int. Cl.: H04N 5/44, H04N 5/50

(54) **Channel selection method and system thereof for receiving a video signal in multi TV broadcasting system**
Verfahren zur Kanalwahl und System für den Empfang eines Videosignals in einem Vielfachfernsehübertragungssystem
Procédé de sélection du canal et système de réception d'un signal vidéo dans un système de transmission de télévision multiple

(30) Priority: 21.04.1990 KR 905636
(43) Date of publication of application: 30.10.1991
(73) Proprietor: SAMSUNG ELECTRONICS CO. LTD., Suwon, Kyunggi-do (KR)
(72) Inventor: Hong, Sang-beom, Seogwipo-shi, Cheju-do (KR)
(74) Representative: WILHELMS, KILIAN & PARTNER Patentanwälte

(56) References cited:
- GB-A- 2 208 981
- US-A- 4 387 400

## Description

### Background of the Invention

The present invention relates to a channel selection method apparatus for a multi TV broadcasting system video receiver which is used in an area where multiple broadcasting systems are available, and which enables a user to select with ease a particular channel of a particular broadcasting system desired by the user.

Generally, a broadcasting system is broadly classified into three types in accordance with a transmission method of color difference signals, and a multiplexing level between color difference signals and luminance signals. The aforesaid three types are exemplified with NTSC (National Television System Committee) system, PAL (Phase Alternation by Line) system and SECAM (Sequentiel Couleur A Mamoire) system. Besides these three types, there are many different broadcasting systems adopted by particular countries.

A video receiver adapted to multi TV broadcasting systems is an apparatus to receive video signals of multiple broadcasting systems. A conventional video receiver for multi TV broadcasting systems is designed to tune in each of a user's desired channels by selecting first a broadcasting system selection switch and then a channel selection switch thereafter.

Thus, such conventional video receiver causes the user inconvenience in having to operate several switches when selecting a channel. In addition, wrong broadcasting programs could be recorded if a user of a VCR makes a mistake in choosing a wrong broadcasting system selection switch when the user wishes to perform a programmed recording of the desired TV broadcasting programs utilizing a timer within the VCR.

From the GB-A-2208981, a channel selection method/apparatus for a video receiver is known which has switch selectable features which enable the receiver to interface to a variety of signal sources by controlling the operating parameters on the television receiver. The controlled parameters are, for example, automatic turn-on, automatic programming, automatic forcing of the television receiver to a predetermined channel, automatic increasing of the volume at the television receiver and automatic disabling of the numeric keyboard of the television receiver. The television receiver includes a tuner having memory means for storing data indicative of preferred channels and control means for autoprogramming the tuner memory means with active channel information and/or for automatically tuning the tuner to a predetermined channel. The control means include means for interrupting the operation of the means for autoprogramming said tuner memory before the autoprogramming function has finished. Furthermore, a local keyboard is included, and the control means includes means for disabling the local keyboard from activation by a user. Furthermore, means are provided coupled to said keyboard for causing the selection of the operating parameters.

The GB-A-2208981, however, does not disclose the adaption of the channel selection method/apparatus to a multi TV broadcasting system.

### Summary of the Invention

It is therefore an object of the present invention to provide a channel selection method apparatus to solve the above-mentioned problems wherein a user can easily and precisely select a desired channel with a video receiver adapted to a multi TV broadcasting system.

In order to accomplish the above-mentioned object, the channel selection method according to the present invention adapted to a multi TV broadcasting system video receiver including a tuner for selecting a high frequency signal of any frequency band received through an antenna, a video signal processor portion for processing the tuned video signals, key input means including a broadcasting system selection switch for selecting a user's desired broadcasting system and a key matrix circuit for inputting a user's desired channel information, memory means for storing the channel information chosen by the key input means, and a microcomputer which analyzes key data input to the microcomputer from the key input means, designates a selection frequency of the tuner in accordance with the analyzed result, controls an operation mode and state of the video signal processor portion and instructs to store the channel selection information in the memory and to read out the stored information from the memory, so as to be used in the area where multiplexed TV broadcasting systems are available, comprises the processes mentioned in claim 1.

The channel selection apparatus according to the present invention adapted to a multi TV broadcasting system video receiver is constructed as it is mentioned in claim 2.

### Brief Description of the Drawings

The above and other objects, features and advantages of the present invention will be more clear from the following detailed description of the illustrated embodiment thereof presented hereinbelow in conjunction with the accompanying drawings wherein;

FIG. 1 is a flow chart diagram showing an embodiment of the present invention.

FIG. 2 is a block diagram serving to schematically illustrate the execution of the embodiment shown in FIG. 1.

FIG. 3 is a constitutional diagram for explaining a write-in operation of 8-bit channel information in a memory.

### Detailed Description of the Preferred Embodiment

A preferable embodiment of the present invention will be described below with reference to the attached drawings.

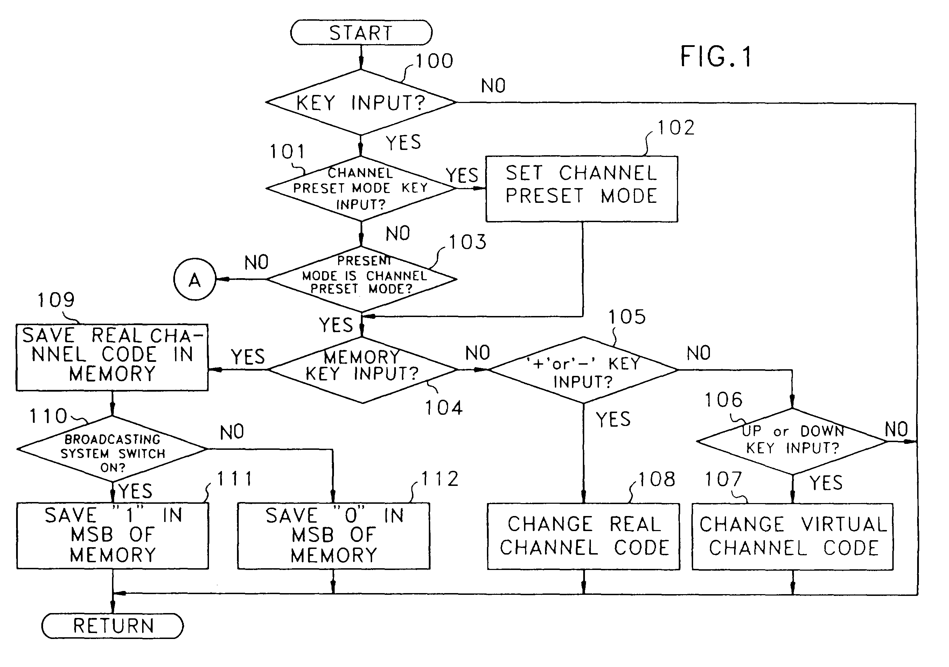

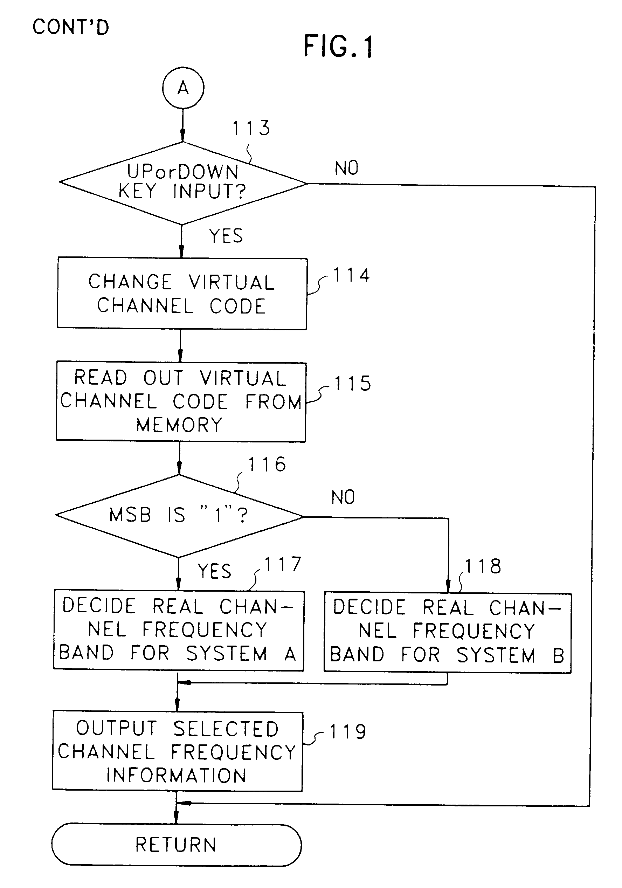

Referring now to FIG. 1 a channel L presetting process is illustrated from step 100 to step 112 and a tuner control process is shown from step 113 to step 119.

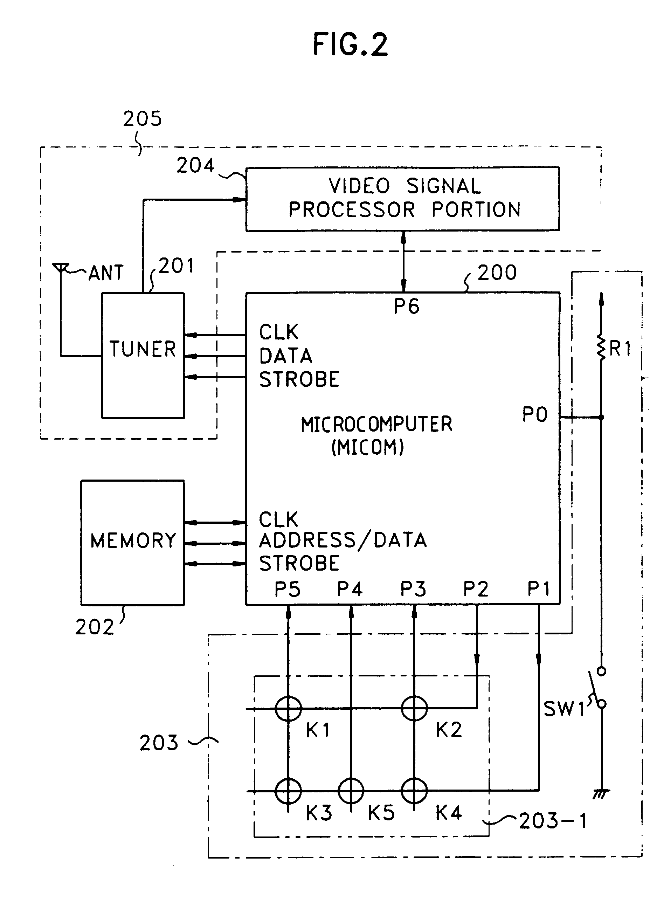

As depicted in FIG. 2, a video receiver 205 for multi TV broadcasting systems to which the indicated invention is applied comprises a tuner 201 for selecting one of the high frequency signals received through antenna ANT and a video signal processor portion 204 for processing video signals of the tuned channel.

The tuner 201 selects a high frequency signal of a frequency band out of high frequency signals received through antenna ANT and outputs the selected signal to the video signal processor portion 204.

The video signal processor portion 204 processes the high frequency signal transmitted from the above-mentioned tuner 201 and records the processed video signal on a recording medium or displays it on a monitor screen.

A channel selection apparatus according to the present invention for adapting a channel selection method to a video receiver 205 comprises key input means 203 for supplying a user's desired channel information to the video receiver 205, memory 202 for storing the channel information chosen by the key input means, and a microcomputer 200 which analyzes key data input from the key input means 203, designates a selected frequency of the tuner in accordance with the analyzed result, controls an operation mode and state of the video signal processor portion and instructs to store the channel selection information in the memory and to read out the stored information from the memory.

The key input means 203 includes a key matrix circuit 203-1 having numerous keys for inputting channel information and a broadcasting system selection switch sw1 for selecting a broadcasting system and inputs the information designated by the user through the key matrix circuit 203-1 and the broadcasting system selection switch, and transmits it to the microcomputer 200, which will be referred to as "micom", hereinafter.

The micom 200 determines the frequency to be selected by the tuner 201 and controls the operating mode and the operating state of the video processor portion 204, and stores channel information in the memory 202 or reads out the information stored in the memory 202 in accordance with the outcome of the analysis of the key data input by the key input means 203.

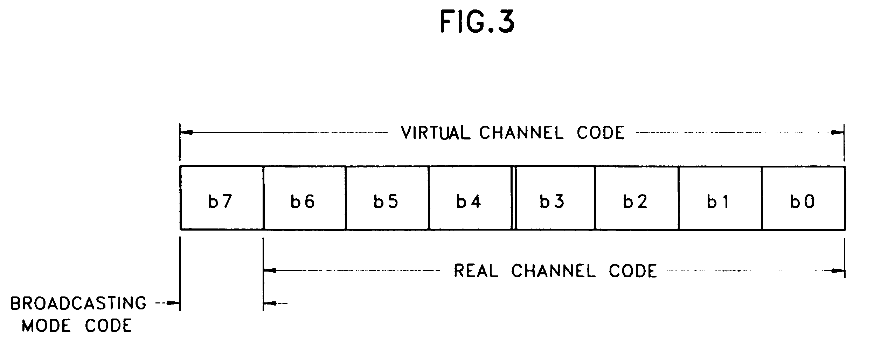

The channel information processed by the aforementioned micom 200 is saved in the memory 202 which is a non-volatile RAM. FIG. 3 illustrates the 8 bit configuration of the memory in which the virtual channel information is to be written. According to FIG. 3, real channel information is written in from the least significant bit b0 to the second most significant bit b6 while broadcasting system information is written in the most significant bit b7.

The micom 200 provides the tuner 201 with data for frequency selection during the low logic state of the strobe signal in accordance with the clock pulse CLK.

For storing the data in the memory 202, the micom 200 provides the memory 202 with addresses for assigning areas to be stored and data to be stored in accordance with clock pulse CLK during the low logic state of the strobe signal, and for reading out the data from the memory 202, the micom 200 reads out the data from the memory 202 during the low logic state of the strobe signal in accordance with the clock pulse CLK after providing the memory 202 with addresses for assigning areas to be stored during the low logic state of the strobe in accordance with clock pulse CLK.

The flow chart shown in FIG. 1 will be explained in detail in association with the circuit illustrated in FIG. 2 hereinbelow.

The channel selection method as shown in FIG. 1 according to the present invention is performed under control of the micom 200. The micom 200 transmits a scanning pulse to a key matrix circuit 203-1 through first and second I/O ports P1 and P2, and then detects through which port the scanning pulse returns among I/O ports P3 to P5. Accordingly, the micom 200 recognizes which one key among the multiple keys on the key matrix circuit 203-1 is pressed the scanning pulse loops therein at step 100.

When the micom 200 recognizes that any key on the key matrix circuit 203-1 is pressed at step 100, the micom 200 judges whether the pressed key is a channel preset mode key or not by means of the scanning pulse at step 101.

If the micom 200 determines that the channel preset mode key has been pressed at step 101, the micom 200 sets a flag of the channel preset mode assigned to its register to "1" so as to set the channel preset mode at step 102.

Otherwise, if the micom 200 determines that the channel preset mode key has not been pressed at step 101, the micom 200 checks whether the flag of the channel preset mode assigned to its register is set to "1" so as to determine that the present mode is a channel preset mode at step 103. When the flag of the channel preset mode is set to "1" at step 103, that is, when the channel preset mode is set, the micom 200 checks whether the pressed key at step 100 is a "memory" key or not at step 104. Then, if it is determined that the pressed key at step 100 is not the memory key at step 104, the micom 200 checks whether the pressed key at step 100 is a "+" or a "-" key or not at step 105. Then, if it is determined that the pressed key at step 100 is not the "+" or the "-" key or not at step 105, the micom 200 checks whether the pressed key at step 100 is an "up" or a "down" key or not at step 106.

If it is determined that the "up" key K3 or the "down" key K4 has been pressed at step 106, the micom 200 adds or subtracts a virtual channel code value stored in one of the registers installed in the micom 200 by "1" at step 107. If not, the micom 200 returns to step 100. When it is determined that the "+" key K1 or the "-" key K2 has been pressed at step 105, the micom 200 adds or subtracts a real channel code value stored in one of the registers installed in the micom 200 by "1" at step 108.

When it is determined that the "memory" key K5 has been pressed at step 104, the micom 200 supplies the virtual channel code value stored in one of the registers installed in the micom 200 to memory 202 and assigns a storage area, that is, an address in the memory 202. Then, the micom 200 supplies the real channel code value to the memory 202 and stores the real channel code value in a least significant bit to the second most significant bit of the storage area assigned by the virtual channel code value within the memory 202 at step 109.

After processing to store the real channel code value in the memory at step 109, the micom 200 reads out a logic value of a broadcasting system selection switch SW1 and judges whether the present broadcasting system is a system A, e.g. PAL system or a system, B, e.g. SECAM system at step 110.

When the logic value of the broadcasting system selection switch sw1 is "1" at step 110, the micom 200 supplies the virtual channel code value to the memory 202 and assigns a storage area in the memory 202. Then, the micom 200 supplies the logic value"1" of the broadcasting system selection switch sw1 to the memory 202 and stores information of the broadcasting system A in a most significant bit of the storage area assigned by the virtual channel code value within the memory 202 at step 111.

When the logic value of the broadcasting system selection switch sw1 is "0" at step 110, the micom 200 supplies the virtual channel code value to the memory 202 and assigns a storage area in the memory 202. Then, the micom 200 supplies the logic value "0" of the broadcasting system selection switch sw1 to the memory 202 and stores information of the broadcasting system B in a most significant bit of the store area assigned by the virtual channel code value within the memory at step 112.

On the other hand, when the flag of the channel preset mode is reset to "0" at step 103, that is, when the channel preset mode is not set, the micom 200 determines whether the pressed key at step 100 is the "up" key or the "down" key by means of the scanning pulse at step 113.

If it is judged that the "up" key or the "down" key is pressed at step 113, the micom 200 adds or subtracts "1" from the virtual channel code value stored in one of the registers installed in the micom 200 and changes the virtual channel code value at step 114.

After processing to change the virtual channel code value at step 114, the micom 200 supplies the changed virtual channel code value to the memory 202 and assigns a storage area in the memory 202. Then, the micom 200 reads out the code value stored in the storage area assigned by the virtual channel code value within the memory 202 at step 115. After processing to read out the stored code value from the memory 202 at step 115, the micom 200 checks a logic value of the most significant bit among the read out code from the memory 202 and judges whether a broadcasting system is a system A or a system B at step 116.

If the logic value of the most significant bit in the code value read out from the memory 202 is "1" at step 116, that is, the broadcasting system is a system A, the micom 200 reads out a frequency band information corresponding to a channel code value represented by the least significant bit to the second most significant bit in the code value read out from the memory 202 among the channel frequency information corresponding to the broadcasting system A stored in a ROM (read-only-memory) installed in the micom 200 at step 117.

If the logic value of the most significant bit in the code value read out form the memory 202 is "0" at step 116, then the broadcasting system is a system B, the micom 200 reads out a frequency band information corresponding to a channel code value represented by the least significant bit to the second most significant bit in the code value read out from the memory 202 among the channel frequency information corresponding to the broadcasting system B stored in the ROM installed in the micom 200 at step 118.

After processing to read out the frequency band information at step 117 or step 118, the micom 200 supplies the frequency band information read out from the ROM installed in the micom 200 to a tuner 20 and instructs the tuner 201 to tune in the selected frequency band of the high frequency at step 119. Accordingly the tuner 201 tunes in the high frequency having the frequency band corresponding to the frequency information supplied from the micom 200 among the high frequency signals input from an antenna ANT and supplies the selected high frequency signal to a video signal processor portion 204.

As described above, the present invention adapted to a video receiver for multi TV broadcasting systems has a merit capable of selecting a desired channel of a desired broadcasting system conveniently and correctly with one-touch operation by replacing the information of a broadcasting system and a real channel with the information of a virtual channel, storing it in a storage area of the memory and selecting the virtual channel information using channel selection switches.

## Claims

1. A channel selection method adapted to a multi TV broadcasting system video receiver including a tuner (201) for selecting a high frequency signal of any frequency band received through an antenna, a video signal processor portion (204) for processing the tuned video signals, key input means (203) including a broadcasting system selection switch (SW1) for selecting a user's desired broadcasting system and a key matrix circuit (203-1) for inputting a user's desired channel information, memory means (202) for storing the channel information chosen by the key input means (203) and a microcomputer (200) which analyzes key data input from the key input means (203), designates a selection frequency of the tuner (201) in accordance with the analyzed result, controls an operation mode and state of the video signal processor portion (204) and instructs to store the channel selection information in the memory (202) and to read out the stored information from the memory (202) so as to be used in the area where multiplexed TV broadcasting systems are available, comprising
a channel presetting process for presetting real broadcasting channels of each broadcasting system with unduplicatedly numbered virtual channels which comprises
a real channel presetting process for presetting the numbers of the real channels by varying numbers of real channels,
a virtual channel presetting process for presetting the numbers of the virtual channels in the respective broadcasting systems by varying numbers of virtual channels after performing said real channel presetting process and
a channel replacing process for storing the real channel code value in a storage area corresponding to the preset virtual channel code, selecting a broadcasting system and storing the information of the broadcasting system in the store area corresponding to the preset virtual channel code and
a tuner control process for controlling the microcomputer (200) to vary the virtual channels based on a channel selection instruction after performing the channel presetting process and for controlling the tuner (201) to select a high frequency signal of a frequency band corresponding to the real broadcasting channel of each broadcasting system in accordance with the varied virtual channel which further comprises a read-out process for reading out the information of the real broadcasting system and the information corresponding to the real broadcasting channel stored in the store area of the memory (202) corresponding to the numbers of the virtual channels.

2. A channel selection apparatus adapted to a multi TV broadcasting system video receiver having a tuner (201) for selecting a high frequency signal of any frequency band received through an antenna, a video signal processor portion (204) for processing the tuned video signals, key input means (203) including a broadcasting system selection switch (SW1) for selecting a user's desired broadcasting system and a key matrix circuit (203-1) for inputting a user's desired channel information, memory means (202) for storing the channel information chosen by the key input means (203) and a microcomputer (200) which analyzes key data input from the key input means (203), designates a selection frequency of the tuner (201) in accordance with the analyzed result, controls an operation mode and state of the video signal processor portion (204) and instructs to store the channel selection information in the memory (202) and to read out the stored information from the memory (202) comprising channel presetting means for presetting real broadcasting channels of each broadcasting system with unduplicatedly numbered virtual channels having real channel presetting means for presetting the numbers of the real channels by varying numbers of real channels, virtual channel presetting means for presetting the numbers of the virtual channels in the respective broadcasting systems by varying numbers of virtual channels after performing the real channel presetting by the real channel presetting means and channel replacing means for storing the real channel code value in a storage area corresponding to the preset virtual channel code, selecting a broadcasting system and storing the information of the broadcasting system in the store area corresponding to the preset virtual channel code and comprising tuner control means for controlling the microcomputer (200) to vary the virtual channels based on a channel selection instruction after performing the channel presetting by the channel presetting means and for controlling the tuner (201) to select a high frequency signal of a frequency band corresponding to the real broadcasting channel of each broadcasting system in accordance with a varied virtual channel having read-out means for reading out the information of the real broadcasting system and the information corresponding to the real broadcasting channel stored in the store area of the memory (202) corresponding to the number of virtual channels.

## Patentansprüche

1. Kanalauswahlverfahren, eingerichtet für ein Multi-Fernsehsendesystem-Fernsehgerät mit einem Tuner (201) zum Auswählen eines Hochfrequenzsignals irgendeines über eine Antenne empfangenen Frequenzbandes, einem Videosignalprozessorteil (204) zur Verarbeitung der abgestimmten Videosignale, Tasteneingabemitteln (203), welche einen SendesystemAuswahlschalter (SW1) zur Auswahl eines von einem Benutzer gewünschten Sendesystems sowie eine Tastenmatrixschaltung (203-1) zur Eingabe einer von einem Benutzer gewünschten Kanalinformation enthalten, Speichermitteln (202) zum Speichern der mit den Tasteneingabemitteln (203) gewählten Kanalinformation und einem Mikrocomputer (200), welcher an den Tasteneingabemitteln (203) eingegebene Tastendaten analysiert, eine Auswahlfrequenz des Tuners (201) nach Maßgabe des Analysierergebnisses bezeichnet, Betriebsweise und -zustand des Videosignal-Prozessorteils (204) steuert und die Speicherung der Kanalauswahlinformation im Speicher (202) und das Auslesen der gespeicherten Information aus dem Speicher (202) anweist, zur Verwendung in einem Gebiet, wo Mehrfach-Fernsehsendesysteme verfügbar sind, welches
einen Kanalvoreinstellprozeß zum Voreinstellen realer Sendekanäle eines jeden Sendesystems mit undupliziert numerierten virtuellen Kanälen, welcher
einen Realkanalvoreinstellprozeß zum Voreinstellen der Nummern realer Kanäle durch Verändern von Nummern realer Kanäle,
einen Virtuellkanalvoreinstellprozeß zum Voreinstellen der Nummern der virtuellen Kanäle in den betreffenden Sendesystemen durch Verändern von Nummern virtueller Kanäle nach Durchführen des Realkanal-Voreinstellprozesses und
einen Kanalersetzungsprozeß zum Speichern des Realkanal-Codewerts in einem dem voreingestellten Virtuellkanal-Code entsprechenden Speicherbereich , Auswählen eines Sendesystems und Speichern der Information des Sendesystems in dem dem voreingestellten Virtuellkanal-Code entsprechenden Speicherbereich aufweist, und
einen Tunersteuerprozeß zur Steuerung des Mikrocomputers (200) für eine Veränderung der virtuellen Kanäle beruhend auf einem Kanalauswahlbefehl nach Durchführung des Kanalvoreinstellprozesses und zur Steuerung des Tuners (201) für eine Auswahl eines Hochfrequenzsignals eines dem realen Sendekanal entsprechenden Frequenzbandes eines jeden Sendesystems nach Maßgabe des veränderten virtuellen Kanals, welcher ferner einen Ausleseprozeß zum Auslesen der Information des realen Sendesystems und der dem realen Sendekanal entsprechenden Information, die in dem Speicherbereich des Speichers (202) gespeichert sind, der den Nummern der virtuellen Kanäle entspricht, aufweist.

2. Kanalauswahlvorrichtung, eingerichtet für ein Multi-Fernsehsendesystem-Fernsehgerät mit einem Tuner (201) zum Auswählen eines Hochfrequenzsignals irgendeines über eine Antenne empfangenen Frequenzbandes, einem Videosignalprozessorteil (204) zur Verarbeitung der abgestimmten Videosignale, Tasteneingabemitteln (203), welche einen Sendesystem-Auswahlschalter (SW1) zum Auswählen eines von einem Benutzer gewünschten Sende systems sowie eine Tastenmatrixschaltung (203-1) zur Eingabe einer von einem Benutzer gewünschten Kanalinformation enthalten, Speichermitteln (202) zum Speichern der mit den Tasteneingabemitteln (203) ausgewählten Kanalinformation und einem Mikrocomputer (200), welcher an den Tasteneingabemitteln (203) eingegebene Tastendaten analysiert, eine Auswahlfrequenz des Tuners (201) nach Maßgabe des Analysierergebnisses bezeichnet, Betriebsweise und - zustand des Videosignalprozessorteils (204) steuert und die Speicherung der Kanalauswahlinformation im Speicher (202) und das Auslesen der gespeicherten Information aus dem Speicher (202) anweist, welche Kanalvoreinstellmittel zum Voreinstellen realer Sendekanäle eines jeden Sendesystems mit undupliziert numerierten virtuellen Kanälen, welche Realkanalvoreinstellmittel zum Voreinstellen der Nummern der realen Kanäle durch Verändern von Nummern realer Kanäle, Virtuellkanalvoreinstellmittel zum Voreinstellen der Nummern der virtuellen Kanäle in den betreffenden Sendesystemen durch Verändern von Nummern der virtuellen Kanäle nach Durchführung der Realkanalvoreinstellung mit den Realkanalvoreinstellmitteln sowie Kanalersetzungsmittel zum Speichern des Realkanalcodewerts in einem dem voreingestellten Virtuellkanalcode entsprechenden Speicherbereich, Auswählen eines Sendesystems und Speichern der Information des Sendesystems in dem dem voreingestellten Virtuellkanalcode entsprechenden Speicherbereich aufweisen, und Tunersteuermittel zur Steuerung des Mikrocomputers (200) für eine Veränderung der virtuellen Kanäle beruhend auf einem Kanalauswahlbefehl nach Durchführung der Kanalvoreinstellung mit den Kanalvoreinstellmitteln und zur Steuerung des Tuners (201) für eine Auswahl eines Hochfrequenzsignals eines dem realen Sendekanal entsprechenden Frequenzbands eines jeden Sendesystems nach Maßgabe eines veränderten virtuellen Kanals aufweist, welche Auslesemittel zum Auslesen der Information des realen Sendesystems und der dem realen Sendekanal entsprechenden Information, die in dem Speicherbereich des Speichers (202) gespeichert sind, der der Nummer virtueller Kanäle entspricht, aufweisen.

## Revendications

1. Procédé de sélection de canal adapté pour un récepteur de signal vidéo d'un système de transmission de signaux de télévision multiples comprenant un tuner (201) pour sélectionner un signal à haute fréquence de toute bande de fréquence reçue par une antenne, une partie de processeur de signal vidéo (204) pour le traitement des signaux vidéo synthonisés, des moyens d'entrée par touches (203) comportant un commutateur de sélection de système de transmission (SW1) pour la sélection d'un système de transmission désiré par un utilisateur et un circuit de matrice de touches (203-1) pour l'entrée d'informations de canal désiré par un utilisateur, des moyens de mémorisation (202) pour le stockage des informations de canal choisi par les moyens d'entrée par touches (203) et un microcalculateur (200) qui analyse les données de codes entrées à partir des moyens d'entrée par touches (203), désigne une fréquence de sélection du tuner (201) en fonction du résultat analysé, contrôle un mode de fonctionnement et l'état de la partie (204) de processeur de signal vidéo et commande le stockage des informations de sélection de canal dans la mémoire (202) et extrait de celle-ci les informations stockées de manière à être utilisée dans la zone dans laquelle les systèmes de transmission de signaux de télévisions multiplexées sont disponibles, comprenant :
un processus de préréglage de canal pour le préréglage de canaux d'émission réels pour chaque système de transmission avec des canaux virtuels numérotés de façon non dupliquée, qui comportent :
un processus de préréglage de canal réel pour le préréglage des nombres de canaux réels en faisant varier les nombres de canaux réels,
un processus de préréglage de canal virtuel pour le préréglage des nombres de canaux virtuels dans les systèmes de transmission respectifs en faisant varier le nombre de canaux virtuels après la réalisation dudit processus de préréglage de canaux réels, et
un processus de remplacement de canal pour le stockage de la valeur de code du canal réel dans une zone de stockage correspondant au code de canal virtuel de présélection, la sélection d'un système de transmission et le stockage des informations du système de transmission dans la zone de stockage correspondant aux codes de canal virtuel de présélection, et
un processus de commande de tuner pour commander le microcalculateur (200) de manière à faire varier les canaux virtuels sur la base des instructions de sélection de canal après la réalisation du processus de présélection de canal et pour contrôler le tuner (201) de manière à sélectionner un signal de haute fréquence et une bande de fréquence correspondant au canal de transmission réel de chaque système de transmission selon le canal virtuel tel que modifié, lequel processus comporte en outre un processus d'extraction pour l'extraction des informations du système de transmission réelle et des informations correspondant au canal de transmission réelle stockées dans la zone d'adresse de la mémoire (202) correspondant aux nombres de canaux virtuels.

2. Appareil de sélection de canal adapté pour un récepteur de signal vidéo d'un système de transmission de signaux de télévision multiples comprenant un tuner (201) pour la sélection d'un signal de haute fréquence parmi toutes bandes de fréquence reçues par une antenne, une partie (204) de processeur de signal vidéo pour le traitement de signaux vidéo synthonisés, des moyens (203) d'entrée par touches comportant un commutateur (SW1) de sélection de ces systèmes de transmission pour la sélection d'un système de transmission désiré par un utilisateur et un circuit (203-1) de matrice de touches pour l'entrée d'informations de canal désiré par un utilisateur, des moyens de mémoire (202) pour le stockage des informations de canal choisi par les moyens d'entrée par touches (203) et un microcalculateur (200) qui analyse des données de codes entrées par les moyens d'entrée par touches (203), désigne une fréquence de sélection du tuner (201) en fonction du résultat analysé, commande un mode de fonctionnement et l'état de la partie (204) de processeur de signal vidéo et commande le stockage d'informations de sélection de canal dans la mémoire (202) et extrait les informations stockées de la mémoire (202), comprenant des moyens de présélection de canal pour la présélection de canaux de transmission réelle de chaque système de transmission avec des canaux virtuels numérotés de façon non dupliquée ayant des moyens de présélection de canaux réels pour la présélection des nombres de canaux réels en faisant varier les nombres de canaux réels, des moyens de présélection de canaux virtuels pour la sélection des nombres de canaux virtuels dans les systèmes de transmission respectifs en faisant varier les nombres de canaux virtuels après la réalisation de la présélection du canal réel par les moyens de présélection de canaux réels et des moyens de remplacement de canal pour stocker la valeur de code de canal réel dans une zone de stockage correspondant au code de canal virtuel de présélection, sélectionner un système de transmission et stocker les informations du système de transmission dans la zone de stockage correspondant au code de canal virtuel de présélection et comprenant des moyens de commande de tuner pour la commande du microcalculateur (200) de manière à faire varier les canaux virtuels sur la base des instructions de sélection de canal après la réalisation de la présélection de canal par les moyens de présélection de canaux et pour commander le tuner (201) de manière à présélectionner un signal de haute fréquence et une bande de fréquence correspondant au canal de transmission réelle de chaque système de transmission en accord avec un canal virtuel modifié, comprenant des moyens d'extraction pour lire les informations du système de transmission réelle et des informations correspondant au canal de transmission réel stockées dans la zone de stockage de la mémoire (202) correspondant au nombre de canaux vituels.
